Europäisches Patentamt

European Patent Office

Office européen des brevets

(11) Veröffentlichungsnummer: **0 307 539 B1**

(12) **EUROPÄISCHE PATENTSCHRIFT**

(45) Veröffentlichungstag der Patentschrift: **09.06.93**

(21) Anmeldenummer: **88106469.5**

(22) Anmeldetag: **22.04.88**

(51) Int. Cl.⁵: **C23C 14/56**

(54) **Verfahren und Vorrichtung zum Beschichten von Substraten.**

(30) Priorität: **18.09.87 DE 3731444**

(43) Veröffentlichungstag der Anmeldung:
**22.03.89 Patentblatt 89/12**

(45) Bekanntmachung des Hinweises auf die
Patenterteilung:
**09.06.93 Patentblatt 93/23**

(84) Benannte Vertragsstaaten:
**AT BE CH DE FR GB IT LI NL**

(56) Entgegenhaltungen:
**EP-B- 0 018 690**
**GB-A- 2 171 119**
**US-A- 3 776 830**

**PATENT ABSTRACTS OF JAPAN, Band 7, Nr.
170 (E-189)[1315], 27 Juli 1983;
N.HASEGAWA: "Continuous vacuum processor"; & JP-A-58 077 239**

**PATENT ABSTRACTS OF JAPAN, Band 9, Nr.
138 (C-286)[1861], 13 Juni 1985;
H.YOSHIHARA: "Continuous working device
for sample; & JP-A-60 024 370**

(73) Patentinhaber: **LEYBOLD AKTIENGESELL-
SCHAFT**
**Wilhelm-Rohn-Strasse 25, Postfach 1555**
**W-6450 Hanau am Main 1(DE)**

(72) Erfinder: **Arnold, Manfred, Dr.**
**Sodener Strasse 51**
**W-8750 Aschaffenburg(DE)**
Erfinder: **Wirz, Peter, Dr.**
**Klosterstrasse 5**
**W-6296 Waldernbach(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren und eine Vorrichtung zum Beschichten von Substraten in einer eine Kathodenanordnung oder eine Verdampferanordnung aufweisenden evakuierten Beschichtungskammer, der evakuierbare Isolierkammern vor- und nachgeschaltet sind, wobei die einzelnen Kammern durch Schleusen voneinander trennbar sind, mit einer in die Beschichtungskammer einmündenden Leitung zum Einspeisen eines oder mehrerer Prozeßgase sowie mit auf Schienen und/oder Rollen gehaltenen und geführten, durch die einzelnen Kammern hindurchbewegbaren Transportgestellen zur Aufnahme der zu beschichtenden Substrate.

Es ist eine Vorrichtung der in Frage stehenden Art bekannt (EP 0 018 690), bei der vor und hinter einer zentralen Beschichtungskammer jeweils mehrere Isolierkammern angeordnet sind, wobei alle Kammern über Schleusen in Verbindung stehen. Die Transportgestelle für die Halterung der plattenförmigen Werkstücke bestehen aus lotrecht angeordneten Tafeln, die jeweils mit einem Fußteil ausgestattet sind, das Rollen oder Gleitschuhe aufweist, die in einem Schienenstrang oder Förderband laufen, das auf dem Boden der Kammern verlegt ist. Die Schleusen, die die einzelnen Kammern voneinander trennen, sind als rechteckige Klappen ausgebildet und so bemessen, daß die lotrecht stehenden, tafelförmigen Halter oder Gestelle mit den an diesen anliegenden Werkstücken, beispielsweise Glasscheiben, gerade durch die von den Klappen freigegebenen rechteckigen Öffnungen in den die Kammern abtrennenden Wände hindurchbewegbar sind. Der Transport der Werkstücke erfolgt schrittweise, d.h. wenn alle auf dem Schienenstrang gelagerten Gestelle oder Halter gleichzeitig jeweils um eine Kammer weiterbewegt sind, schließen alle Klappen die Kammern hermetisch ab, und die Gestelle mit den Werkstücken verweilen in den jeweiligen Kammern für die Dauer eines Beschichtungsvorganges. Die Einschleus- und Ausschleuskammern stehen ebenso wie die Beschichtungskammer mit Vakuumpumpen in Verbindung, so daß der Druck in den Kammern auf gleichem Niveau gehalten werden kann. Diese Vorrichtung hat den Nachteil, daß bei einem Beschichtungsvorgang in einer reaktiven Gasatmosphäre die Gaskonzentrationen bei einem Umschleusvorgang, d.h. bei jedem Öffnen und Schließen der Schleusen zwischen der Beschichtungskammer und den anschließenden Isolierkammern, verändert werden, was dann zu ungleichmäßigen Schichtqualitäten führt, da einerseits im für den Prozeß notwendigen Edelgas-/Reaktivgasgemisch der Anteil an Reaktivgas, der durch Reaktionen verbraucht wird, von entscheidender Bedeutung ist, sich aber andererseits gerade dieser Parameter weder durch Druckmessungen noch durch Druckflußmessungen kontrollieren läßt.

Der vorliegenden Erfindung liegt deshalb die Aufgabe zugrunde, ein Verfahren und eine Vorrichtung der in Frage stehenden Art zu schaffen, bei der sich der Prozeß auch im dynamischen Betrieb, d.h. bei sich vor der Kathode oder Verdampfereinrichtung vorbeibewegenden Substraten, stets im gleichen reaktiven Zustand halten läßt, so daß die Schichtdicke und Schichtqualität von Substrat zu Substrat ein Höchstmaß an Gleichmäßigkeit aufweist.

Erfindungsgemäß wird dies durch ein Verfahren mit einer oder mehreren Bypassleitungen erreicht, die jeweils die Beschichtungskammer mit der ihr vor- oder nachgeschalteten Isolierkammer verbindet, wobei in jede Bypassleitung zum Zwecke eines sanften Druckausgleichs zwischen den jeweils benachbarten Kammern ein Ventil oder Absperrorgan eingeschaltet ist.

Vorzugsweise sind bei der zugehörigen Vorrichtung in die die Kammern mit den Vakuumpumpständen verbindenden Saugleitungen Ventile eingeschaltet, die mit den Ventilen der Bypassleitungen derart synchron geschaltet sind, daß ein Schließen eines Ventils der Absaugleitung der jeweiligen Isolierkammer das gleichzeitige oder zeitlich verzögerte Öffnen des Ventils der entsprechenden Bypassleitung bewirkt.

Durch einen auf diese Weise vorher durchgeführten Druckausgleich zwischen Prozeß- und Isolierkammern wird automatisch gewährleistet, daß auch während des Umschleusens der Substrathalter die einzelnen Gaskonzentrationen an der Kathode konstant bleiben, was für die Stabilität des Prozesses und für stets gleichbleibende Schichteigenschaften von entscheidender Bedeutung ist.

Um einen vollständig automatisierten Betrieb zu ermöglichen, ist das den Zufluß von Reaktivgas in die Beschichtungskammer dosierende Ventil über eine Steuerleitung mit der die Kathodenanordnung mit elektrischer Energie versorgenden Vorrichtung gekoppelt, wobei über die Menge des in die Beschichtungskammer einströmenden Reaktivgases die den Prozeß charakterisierenden Parameter, wie Kathodenspannung oder alternativ Kathodenstrom, konstant gehalten werden.

Die Erfindung läßt die verschiedensten Ausführungsmöglichkeiten zu; eine davon ist in den anhängenden Zeichnungen näher dargestellt, und zwar zeigen:

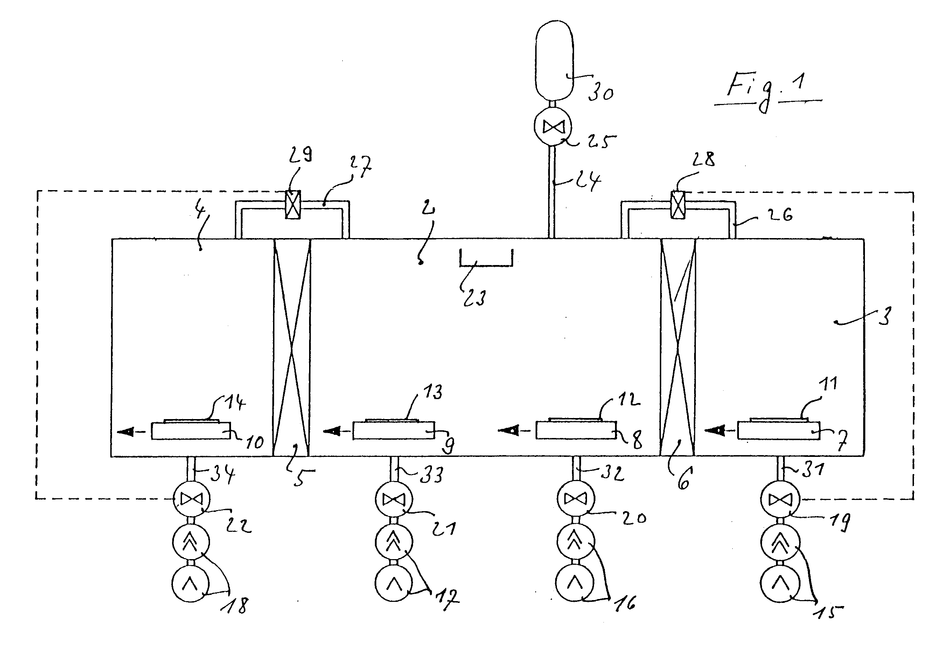

Figur 1     die rein schematische Darstellung einer Vorrichtung zum Beschichten von auf beweglichen Gestellen aufgebrachten Substraten mit einer Beschichtungskammer, einer dieser zugeordneten Einschleus- und einer Ausschleuskammer und mit die be-

Figur 2 der in Diagrammen dargestellte Einfluß des über die Bypassleitung erzeugten Druckausgleichs zwischen der Einschleus- und der Beschichtungskammer auf verschiedene Prozeßparameter

Die Vorrichtung besteht im wesentlichen aus einer Beschichtungskammer 2, einer dieser vorgeschalteten Einschleuskammer 3 und einer nachgeschalteten Ausschleuskammer 4, ferner aus den zwischen der Beschichtungskammer 2 und den sich an diese anschließenden Kammern 3, 4 angeordneten Schleusen 5, 6 aus den auf einer nicht näher dargestellten Rollenbahn beweglichen Transportgestellen 7 bis 10 für die zu beschichtenden Substrate 11 bis 14, aus mehreren an die Kammern 2, 3, 4 angeschlossenen Vakuumpumpständen 15 bis 18 und diesen jeweils zugeordneten Absperrorganen 19 bis 22, einer in der Beschichtungskammer 2 vorhandenen Kathodenanordnung 23, einem mit dieser Kammer über eine Leitung 24 mit zwischengeschaltetem Dosierventil 25 verbundenen Speicher 30 für Edelgas und Reaktivgas und den beiden jeweils die Beschichtungskammer 2 mit der Einschleuskammer 3 bzw. der Ausschleuskammer 4 verbindenden Bypassleitungen 26, 27 mit in diese Bypassleitungen 26, 27 eingeschalteten Absperrorganen 28, 29.

In der Beschichtungskammer 2 wird die Kathode 23 im reaktiven Betrieb gefahren. Dazu ist es notwendig, daß in der Beschichtungskammer 2 stets ein definiertes Edelgas-/Reaktivgasgemisch vorhanden ist. Die Stöchiometrie der auf die Substrate 11 bis 14 gesputterten Schichten ist durch den Zustand der Kathode 23 bestimmt. Hierfür ist der reaktive Gasanteil der entscheidende Parameter. Üblicherweise wird der Einlaß des Reaktivgases über die Leitung 24 so gesteuert, daß durch ihn die Kathodenspannung konstant gehalten wird ($U_{Kathode}$ = const., wobei $U_{Kathode}$ eine Funktion des Reaktivgasflusses ist).

Der Beschichtungsvorgang soll nicht nur im statischen, sondern auch im dynamischen Betriebszustand, in dem sich die Transportgestelle 7 bis 10 vor der Kathodenanordnung 23 vorbeibewegen, stets im gleichen reaktiven Zustand gehalten werden, um von Substrat zu Substrat 11 bis 14 konstante Schichteigenschaften zu gewährleisten. Die Einschleuskammer 3, deren Funktion darin besteht, die verschiedenen Prozesse voneinander zu separieren, ist vor der Beschichtungskammer 2 eingebaut. Ein Übersprechen von einer Prozeßkammer zu anderen wird dadurch verhindert, daß das Transportgestell in der Einschleuskammer 3 bzw. Ausschleuskammer 4 kurzzeitig verweilt und während dieser Zeit diese Kammer bei geschlossener Schleuse 5, 6 zu der Beschichtungskammer 2 auf Hochvakuum evakuiert wird. Beim nachfolgenden Einschleusen in die nächste Kammer darf durch Öffnen der Schleuse 5 bzw. 6 der Reaktivprozeß nicht beeinflußt werden. Dazu ist ein Druckausgleich zwischen der Einschleus- bzw. Ausschleuskammer 3, 4 einerseits und der Beschichtungskammer 2 andererseits durchzuführen. Hierzu kann der Druck oder der Reaktivgasfluß in der Beschichtungskammer 2 gemessen werden, wobei vor dem Einschleusvorgang der gleiche Druck oder Gasfluß in der Einschleuskammer 3 herzustellen ist. Der relevante Parameter ist allerdings der Anteil von Reaktivgas, der durch die Reaktion verbraucht wird. Dieser Anteil ist aber weder durch Druck- noch durch Flußmessungen zu kontrollieren.

Ein exakter Druckausgleich zwischen der Beschichtungskammer 2 und der Einschleuskammer 3 ohne Veränderung der Gaskonzentrationen an der Kathode wird durch die Bypassleitung 26 erreicht. Bevor die Schleuse 6 geöffnet wird, wird in der Einschleuskammer 3 das Ventil 19 zum Vakuumpumpstand 15 geschlossen und gleichzeitig oder zeitlich verzögert das Absperrorgan 28 der Bypassleitung 26 geöffnet. Über diese Bypassleitung findet nun ein "sanfter" Druckausgleich zwischen beiden Kammern 2, 3 statt. Dabei wird exakt das richtige Edelgas-/Reaktivgasgemisch in die Einschleuskammer 3 eingelassen, so daß nach erfolgtem Ausgleich beim Öffnen der Schleuse 6 weder ein Druckstoß noch eine Änderung des Gasgemisches die Prozeßparameter, d.h. konkret den Zustand der Kathode 23, verändert. Durch diese Maßnahme wird gewährleistet, daß ein kontinuierlicher Fahrbetrieb der Transportgestelle 7 bis 10 ohne Beeinflussung der Schichteigenschaften erfolgen kann.

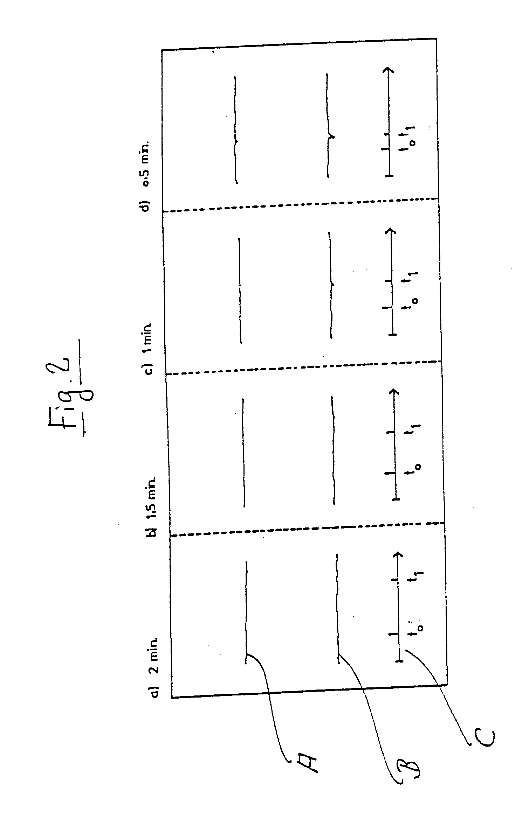

Figur 2 zeigt die experimentellen Ergebnisse, die den Einfluß dieser Maßnahme auf Druck- und Kathodenspannung dokumentieren, wobei mit A die Kathodenspannung, mit B der Sputterdruck und mit C die Ausgleichszeit bezeichnet sind.

Für verschiedene Öffnungszeiten der Bypassleitung 26, 27 (0,5 min - 2 min) ist der Einfluß des Druckausgleichs auf die relevanten Prozeßparameter (Kathodenspannung $U_c$ bzw. Sputterdruck p) gezeigt. Auf der Zeitachse t ist der Zeitpunkt $t_0$ des Öffnens der Schleuse angegeben. Es ist zu sehen, daß Ausgleichszeiten $t_0$ - $t_1$, zu denen die Ventile 28 bzw. 29 der Bypassleitungen 26, 27 geöffnet sind, von mehr als 1 Minute sich überhaupt nicht auf Kathodenspannung oder Druck in der Prozeßkammer auswirken. Diese Zeiten sind auch im dynamischen Betrieb gewährleistet. Erst bei einer Ausgleichszeit $t_0$ - $t_1$ = 0,5 min sind ein merklicher Druckeinbruch ( p = 3 x $10^{-4}$ mbar) sowie ein Spannungsabfall ( $U_c$ = 2 - 3 V) vorhanden. Das Öffnen des Bypassventils 28 bzw. 29 hat aufgrund des geringen Leitwertes der Bypassleitung 26 bzw. 27 generell keinen Einfluß auf den Reaktivprozeß.

Auflistung der Einzelteile:

| | |
|---|---|
| 2 | Beschichtungskammer |
| 3 | Einschleuskammer, Isolierkammer |
| 4 | Ausschleuskammer, Isolierkammer |
| 5 | Schleuse |
| 6 | Schleuse |
| 7 | Transportgestell, Halter |
| 8 | Transportgestell, Halter |
| 9 | Transportgestell, Halter |
| 10 | Transportgestell, Halter |
| 11 | Substrat, Werkstück |
| 12 | Substrat, Werkstück |
| 13 | Substrat, Werkstück |
| 14 | Substrat, Werkstück |
| 15 | Vakuumpumpstand |
| 16 | Vakuumpumpstand |
| 17 | Vakuumpumpstand |
| 18 | Vakuumpumpstand |
| 19 | Absperrorgan |
| 20 | Absperrorgan |
| 21 | Absperrorgan |
| 22 | Absperrorgan |
| 23 | Kathode |
| 24 | Gaseinlaßleitung |
| 25 | Dosierventil |
| 26 | Bypassleitung |
| 27 | Bypassleitung |
| 28 | Absperrorgan |
| 29 | Absperrorgan |
| 30 | Speicher |
| 31 | Absaugleitung |
| 32 | Absaugleitung |
| 33 | Absaugleitung |
| 34 | Absaugleitung |

## Patentansprüche

1. Verfahren zum Beschichten von Substraten (11 bis 14) in einer eine Kathodenanordnung oder eine Verdampferanordnung aufweisenden evakuierten Beschichtungskammer (2), der evakuierbare Isolierkammern (3, 4) vor- und nachgeschaltet sind, wobei die einzelnen Kammern (2 bis 4) durch Schleusen (5, 6) voneinander trennbar sind, mit einer in die Beschichtungskammer (2) einmündenden Leitung (24) zum Einspeisen eines oder mehrerer Prozeßgase sowie mit auf Schienen und/oder Rollen gehaltenen und geführten, durch die einzelnen Kammern (2 bis 4) hindurchbewegbaren Transportgestellen (7 bis 10) zur Aufnahme der zu beschichtenden Substrate (11 bis 14), **gekennzeichnet durch** eine oder mehrere Bypassleitungen (26, 27), die jeweils die Beschichtungskammer (2) mit der ihr vor- oder nachgeschalteten Isolierkammer (3 bzw. 4) verbindet, wobei in jede Bypassleitung (26, 27) zum Zwecke eines sanften Druckausgleichs zwischen dem jeweils benachbarten Kammern (3 und 2 bzw. 2 und 4) ein Absperrorgan oder Ventil (28 bzw. 29) eingeschaltet ist.

2. Vorrichtung zur Durchführung des Verfahrens nach Anspruch 1, **dadurch gekennzeichnet**, daß in den die Kammern (2, 3, 4) mit den Vakuumpumpständen (15 bis 18) verbindenden Saugleitungen (31 bis 34) Ventile (19 bis 22) eingeschaltet sind, die mit den Ventilen (28, 29) der Bypassleitungen (26, 27) derart synchron geschaltet sind, daß ein Schließen eines Ventils (19 bzw. 22) der Absaugleitung (31 bzw. 34) der jeweiligen Isolierkammer (3 bzw. 4) das gleichzeitige oder zeitlich verzögerte Öffnen eines Ventils (28 bzw. 29) der entsprechenden Bypassleitung bewirkt.

3. Vorrichtung nach Anspruch 2, **dadurch gekennzeichnet**, daß durch den Druckausgleich über die Bypassleitungen (26 bzw. 27) die für die Stabilität eines in der Prozeßkammer (2) ablaufenden Reaktivprozesses unbedingt notwendige Konstanz des Edelgas-/Reaktionsgasmischungsverhältnisses automatisch auch beim Öffnen der Schleusen (5 bzw. 6) zum Weitertransport der mit zu beschichtenden Substraten (11 bis 14) beladenen Transportgestelle (7 bis 10) gewährleistet ist, so daß die Schichteigenschaften beim dynamischen Beschichtungsbetrieb konstant gehalten werden.

4. Vorrichtung nach den Ansprüchen 2 und 3, **dadurch gekennzeichnet**, daß das den Zufluß von Reaktivgas in die Beschichtungskammer (2) dosierende Ventil (25) über eine Steuerleitung mit der die Kathodenanordnung (23) mit elektrischer Energie versorgenden Vorrichtung gekoppelt ist, wobei über die Menge des in die Beschichtungskammer (2) einströmenden Reaktivgas die den Prozeß charakterisierenden Parameter, wie Kathodenspannung oder alternativ Kathodenstrom, konstant gehalten werden.

## Claims

1. A method of coating substrates (11 to 14) in an evacuated chamber (2) containing a cathode arrangement or an evaporator arrangement and comprising upstream and downstream isolation chambers (3, 4), the individual chambers (2 to 4) being separated by locks (5, 6), a line (24) for supplying one or more process gases opening into the coating chamber (2) and conveying frames (7 to 10) for holding the substrates (11 to 14) being held and guided on rails and/or rollers and movable through the individual chambers (2 to 4), characterised by one or more bypass lines (26, 27) respectively connecting the coating chamber (2) to the upstream or downstream insulation chamber (3 or 4), a shut-off means or valve (28 or 29) being incorporated in each bypass line (26, 27) for gently compensating the pressure between each pair of adjacent chambers (3 and 2 or 2 and 4).

2. A device for working the method according to claim 1, characterised in that valves (19 to 22) are incorporated in the suction lines (31 to 34) connecting the chambers (2, 3, 4) to the vacuum pump stations (15 to 18), and the valves (19 to 22) are connected in synchronism with the valves (28, 29) in the bypass lines (26, 27) so that when a valve (19, 22) in the suction line (31, 34) of the respective insulation chamber (3, 4) is closed, a valve (28, 29) in the corresponding bypass line is opened simultaneously or after a delay.

3. A device according to claim 2, characterised in that as a result of the pressure compensation via the bypass lines (26, 27) the noble gas/reaction gas mixture ratio is automatically kept constant, as essential for the stability of a reaction process occurring in the chamber (2), even after opening the locks (5, 6) for conveying the frames (7 to 10) loaded with substrates (11 to 14) for coating, so that the properties of the layers are kept constant during dynamic coating.

4. A device according to claims 2 and 3, characterised in that the valve (25) metering the supply of reactive gas to the coating chamber (2) is coupled by a control line to the device supplying electric energy to the cathode arrangement (23), and the parameters characterising the process, such as the cathode voltage or alternatively the cathode current, are kept constant via the amount of reactive gas flowing into the coating chamber (2).

**Revendications**

1. Procédé de revêtement de substrat (11 à 14) dans une chambre de revêtement (2) qui est mise sous vide, qui présente une disposition avec cathode ou une disposition avec vaporisation sous vide, et chambre en avant et en arrière de laquelle sont placées des chambres d'isolation (3, 4) qui peuvent être mises sous vide, procédé dans lequel différentes chambres (2 à 4) peuvent être séparées l'une de l'autre par des écluses (5, 6), avec une conduite (24) débouchant dans la chambre de revêtement (2) pour amener un ou plusieurs gaz de processus ainsi qu'avec des chariots de transport (7 à 10) qui peuvent se déplacer à travers les différentes chambres (2 à 4) maintenus et guidés sur des rails et/ou des galets, pour recevoir les substrats à déposer (11 à 14), procédé caractérisé par une ou plusieurs conduites de bypass (26, 27) dont chacune relie la chambre de revêtement (2) avec la chambre d'isolation (3 ou 4) placée devant ou derrière cette chambre de revêtement, procédé dans lequel un organe d'obturation ou une vanne (28 ou 29) est, dans le but de compenser en douceur la pression, mis en circuit entre les chambres (3 et 2 ou 2 et 4) respectivement voisines.

2. Dispositif pour la mise en oeuvre du procédé selon la revendication 1, caractérisé par le fait que dans les conduites d'aspiration (31 à 34) reliant les chambres (2, 3, 4) avec les postes de pompe à vide (15 à 18), sont mises en circuit des vannes (19 à 22) qui fonctionnent en synchronisme avec les vannes (28, 29) des conduites de bypass (26, 27) de façon qu'une fermeture d'une vanne (19 ou 22) de la conduite d'aspiration (31 ou 34) de la chambre d'isolation respective (3) opère l'ouverture, simultanée ou retardée dans le temps, d'une vanne (28 ou 29) de la conduite de bypass correspondante.

3. Dispositif selon la revendication 2, caractérisé par le fait que par suite de la compensation de pression par l'intermédiaire des conduites de bypass (26 ou 27), est automatiquement garantie la constance, impérativement nécessaire pour la stabilité d'un processus réactif se déroulant dans la chambre de processus (2), du rapport de mélange gaz noble/gaz de réaction, même lors de l'ouverture des écluses (5 ou 6) pour la poursuite du transport des chariots de transport (7 à 10) chargés des substrats à revêtir (11 à 14), de sorte que les caractéristiques de la couche sont maintenues constantes pendant l'exploitation dynamique du revêtement.

4. Dispositif selon les revendications 2 et 3, caractérisé par le fait que la vanne (25) qui dose le flux d'arrivée du gaz réactif dans la chambre de revêtement (2) est couplée, par l'intermédiaire d'une conduite de commande, avec le dispositif qui alimente en énergie électrique le dispositif avec cathode (23), dispositif dans lequel c'est par l'intermédiaire de la quantité de gaz réactif qui s'écoule dans la chambre de revêtement (2) que l'on maintient constants des paramètres caractérisant le processus comme la tension de cathode ou en variante l'intensité de cathode.

Fig. 1

EP 0 307 539 B1

Fig. 2

a)  2 min.        b)  1,5 min.        c)  1 min.        d)  0,5 min.

A

B

C

$t_0$  $t_1$        $t_0$  $t_1$        $t_0$  $t_1$        $t_0$  $t_1$

EP 0 307 539 B1

8